# EUROPEAN PATENT APPLICATION

(11) **EP 2 957 661 A1**
(43) Date of publication of application: **23.12.2015**
(21) Application number: 15171309.6
(22) Date of filing: 10.06.2015
(51) Int. Cl.: C25D 5/56, C25D 5/02, C23C 18/20, H05K 3/18, C23C 18/18

(54) **METHOD OF FORMING METALLIC PATTERN ON POLYMER SUBSTRATE**

(30) Priority: 16.06.2014 US 201414304982; 27.06.2014 US 201414316809
(71) Applicant: Wistron NeWeb Corporation, Hsinchu 308 (TW)
(72) Inventor: Radi, Babak, 308 Hsinchu (TW); Kuo, Yu-Fu, 308 Hsinchu (TW); Chen, Shih-Hong, 308 Hsinchu (TW); Chuang, Tzu-Wen, 308 Hsinchu (TW)
(74) Representative: Becker Kurig Straus

(57) **Abstract**

A method of forming a metallic pattern on a polymer substrate is provided. A mixture layer is formed on a polymer substrate surface. The mixture layer includes an active carrier medium and nanoparticles dispersed in the active carrier medium. A laser process is performed to treat a portion of the mixture layer to form a conductive pattern or active seed residues on the surface of the polymer substrate. A cleaning process is performed to remove an untreated portion of the mixture layer to expose the surface of the polymer substrate, while the conductive pattern or the active seed residues are remained on the surface of the polymer substrate. Then, the conductive pattern or the active seed residues on the polymer substrate are subjected to an electroplating process to form the metallic pattern over the conductive pattern on the polymer substrate.

## Description

### BACKGROUND OF THE INVENTION

### 1. Field of the Invention

The present invention generally relates to a process, in particular, to a method of forming a metallic pattern on a polymer substrate.

### 2. Description of Related Art

As technology advances, portable electronic devices, such as smart phones, tablet PCs, notebook PCs, etc., becomes more compact and lighter for easy carrying. For the purpose of miniaturization, the portable electronic device may be incorporated complicated circuitry as well as antenna formed by the LDS (laser direct structuring) technology, for compactness and efficiency. However, special LDS materials and specialized instruments required for the LDS technology lead to high production costs.

### SUMMARY OF THE INVENTION

Accordingly, the present invention is directed to a manufacturing method of a metallic pattern over a polymer substrate, which offers high quality products with lower production costs.

The present invention provides a method of forming a metallic pattern on a polymer substrate. A mixture layer is formed on a polymer substrate surface. The mixture layer includes an active carrier medium and nanoparticles dispersed in the active carrier medium. A laser process is performed to treat a portion of the mixture layer to form a conductive pattern or active seed residues on the surface of the polymer substrate. A cleaning process is performed to remove an untreated portion of the mixture layer to expose the surface of the polymer substrate, while the conductive pattern or the active seed residues are remained on the surface of the polymer substrate. Then, the conductive pattern or the active seed residues on the polymer substrate are subjected to a plating process to form the metallic pattern over the conductive pattern or the active seed residues on the polymer substrate.

According to an embodiment of the invention, the plating process is an electroplating process and the conductive pattern is subjected to the electroplating process to form the metallic pattern. Alternatively, the plating process is an electroless plating process and the active seed residues are subjected to the electroless plating process to form the metallic pattern.

According to an embodiment of the invention, a material of the polymer substrate includes nylons, polycarbonates (PC), acrylonitrile butadiene styrene (ABS), PC/ABS, polyethylene terephthalate (PET), polyether ether ketone (PEEK), polytetrafluoroethylene (PTFE) or liquid crystal polymers (LCP).

According to an embodiment of the invention, a material of the nanoparticles includes copper oxide, copper, silver or gold.

According to an embodiment of the invention, a material of the nanoparticles includes copper oxide. The laser process is performed by using a UV laser at 355 nm with a power of 0.2∼0.4 W and 80% overlapping of laser spots and the laser process is a laser ablation process. The conductive pattern is a copper layer.

According to an embodiment of the invention, the electroplating process includes a copper electroplating process and the metallic pattern includes a copper pattern. According to an embodiment of the invention, a content of the nanoparticles in the mixture layer ranges from 20 wt% to 40 wt%, relative to a total weight of the mixture layer.

According to an embodiment of the invention, a material of the nanoparticles includes copper oxide. The laser process is performed by using a UV laser at 355 nm with a power of 0.2∼0.4 W and 80% overlapping and the laser process is a laser ablation and activation process. The active seed residues are copper residues. Alternatively, a material of the nanoparticles includes silver. The laser process is performed by using a green light laser at 532 nm or an IR laser at 1064 nm.

According to an embodiment of the invention, the electroless plating process includes an electroless copper plating process and the metallic pattern includes a copper pattern. According to an embodiment of the invention, a content of the nanoparticles in the mixture layer ranges from 10 wt% to 20 wt%, relative to a total weight of the mixture layer.

According to an embodiment of the invention, the nanoparticles have an average size below 100 nm.

According to an embodiment of the invention, a material of the active carrier medium includes polyvinylpyrrolidone (PVP) or polyethylene oxide (PEO).

According to an embodiment of the invention, the step of forming the mixture layer includes forming the mixture layer by spraying, spin coating, dip coating, screen printing, pad printing or smearing.

According to an embodiment of the invention, a position of the conductive pattern or the active seed residues corresponds to a position of the metallic pattern.

In order to make the aforementioned and other features and advantages of the invention more comprehensible, several embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
Figures 1-5 schematically illustrate a method of forming a metallic pattern on a polymer substrate according to an embodiment of the present invention.
Figures 6-10 schematically illustrate a method of forming a metallic pattern on a polymer substrate according to another embodiment of the present invention.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts. In the following embodiment, a circuit trace part of a portable device is described as an example for illustration. It is not intended to limit the method or the part structure by the exemplary embodiments described herein.

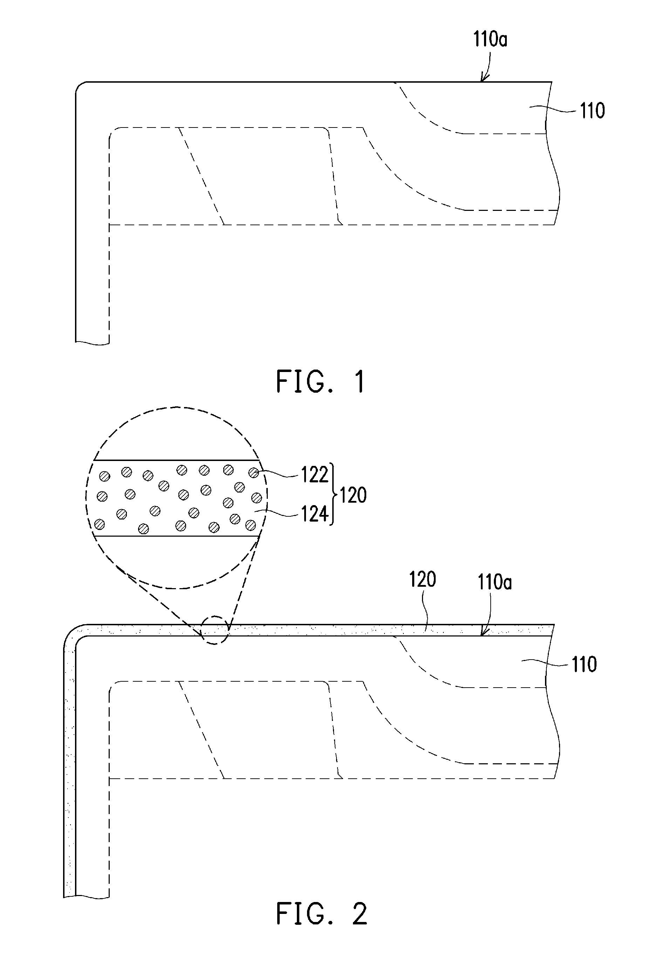

Figures 1-5 schematically illustrate a method of forming a metallic pattern on a polymer substrate according to an embodiment of the present invention. Referring to Figure 1, a polymer substrate 110 is provided. The polymer substrate 110 may be a polymer film, a casing body or even a circuit board, and may be made of a polymer material by injection molding technology. The polymer material may be nylons, polycarbonates (PC), acrylonitrile butadiene styrene (ABS), PC/ABS, polyethylene terephthalate (PET), polyether ether ketone (PEEK), polytetrafluoroethylene (PTFE), liquid crystal polymers (LCP) or any suitable plastic material(s). The polymer substrate 110 needs not to be made of LDS-specific polymers (i.e. the polymer materials specifically designed for the laser direct structuring (LDS) process). The polymer substrate 110 may be a part or parts of an electronic device, and the electronic device may be, for example, a smart phone or a tablet PC, and the metallic pattern may be an antenna part or a three-dimensional circuit incorporated within the electronic device.

Subsequently, referring to Figure 2, a mixture layer 120 is formed on the surface 110a of the polymer substrate 110 by spraying, spin coating, dip coating, screen printing, pad printing or smearing, for example. The mixture layer 120 includes at least nanoparticles 122 and an active carrier medium 124. The nanoparticles 122 may be metallic nanoparticles made of copper oxide, or metal nanoparticles made of copper, silver or gold, for example. Preferably, the nanoparticles 122 may be copper oxide nanoparticles, for example. The nanoparticles may have an average size below 100 nm, for example. The content of the nanoparticles 122 of the mixture layer 120 may be at least 20 wt%, preferably 20 wt%∼40 wt%, relative to the total weight of the mixture layer 120. The material of the active carrier medium 124 may be polyvinylpyrrolidone (PVP), polyethylene oxide (PEO) and the like. In general, the active carrier medium 124 may be removed in the subsequent process by solvent washing and laser treatment, for example.

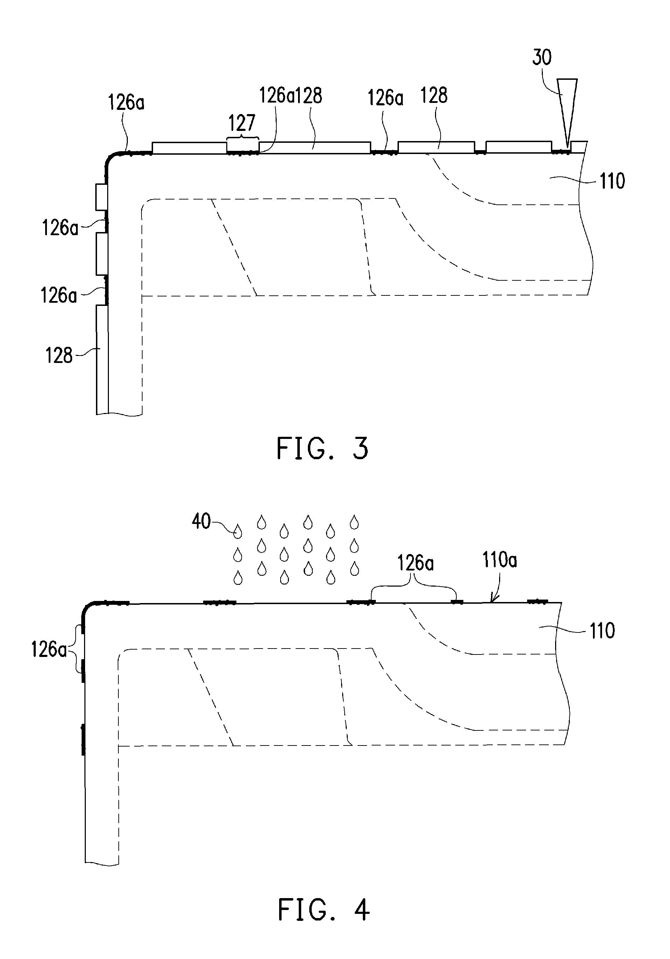

Referring to Figure 3, a laser process 30 is performed to treat a portion of the mixture layer 120 to form a conductive portion 126a. The position of the conductive portion 126a corresponds to the position of the metallic pattern to be formed in the subsequent process. The type of the laser used in the laser process depends on the type and size of the nanoparticles 122 within the mixture layer 120. For treating the copper oxide nanoparticles, the laser used in the laser process 30 may be a UV laser at 355 nm with a power of 0.2∼0.4 W and 80% overlapping of laser spot for example. For treating the silver nanoparticles, the laser used in the laser process 30 may be a green light laser at 532 nm, for example. Basically, the intensity of the laser may be relatively lower due to high surface area and absorption of the nanoparticles through surface plasmon resonance effect. For example, the laser process 30 is a laser ablation process.

Upon laser illumination, nanoparticles, especially metal or metallic nanoparticles, efficiently generate heat (release heat) and the released heat transfers from the nanoparticles to the surrounding matrix or medium. The heating effect of the nanoparticles becomes strongly enhanced under plasmon resonance or when the laser frequency hits the collective resonance of the nanoparticle.

Taking advantages of the heating effect enhanced under plasmon resonance, the nanoparticles 122 in the treated portion 127 of the mixture layer 120 are fused and turned into the conductive pattern 126a during the laser process 30 and the conductive pattern 126a is tightly fixed to the surface 110a. Because the formation of the conductive pattern 126a is activated by laser, the location and the shape of the pattern can be precisely controlled. The conductive pattern 126a may be a very thin conductive layer (a metal layer or a metallic layer) of a continuous pattern or discontinuous patterns. The thickness of the conductive pattern 126a may be very thin and less than 1 micron, as long as it remains to be conductive. Using the nanoparticles made of copper oxide as an example, the conductive pattern 126a may be a very thin copper layer. The conductive pattern 126a can function as the conductive seed layer for the subsequent electroplating process.

Referring to Figure 4, after the laser process 30, a cleaning process 40 is performed to remove the untreated portion 128 (see Figure 3) of the mixture layer 120 to expose the surface 110a of the polymer substrate 110, while the conductive pattern 126a is remained on the surface 110a of the polymer substrate 110. The solvent used in the cleaning process may be water, acetone or suitable alcohols, for example.

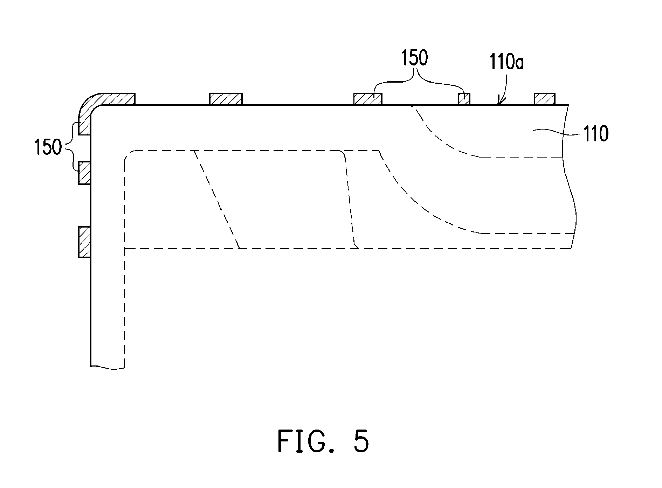

Referring to Figure 5, the polymer substrate 110 and the conductive pattern 126a remained on the surface 110a of the polymer substrate 110 are further processed with an electroplating process to form a metallic pattern 150. As the conductive pattern 126a functions as the conductive seed layer for electroplating, the metallic pattern 150 is formed exactly on the conductive pattern 126a. The region other than that occupied by the conductive pattern 126a (i.e. the exposed polymer surface 110a from the removal of the untreated portion 128) is not conductive and no electroplating occurs. The conductive pattern 126a is merely a very thin metal layer, it can be easily incorporated into the metallic pattern 150 during the electroplating process and both may be viewed as an integral body. For example, the electroplating process may be a copper electroplating process, the conductive pattern 126a may be a very thin copper layer and the metallic pattern 150 may be a copper pattern. A thickness of the metallic pattern 150 may be no more than 20 microns, for example. Because the position of the conductive portion 126a corresponds to the position of the metallic pattern 150, the metallic pattern 150 may be composed of a continuous pattern or discontinuous patterns. Also, since the location and the shape of the conductive pattern 126a can be precisely controlled, the pattern fidelity of the metallic pattern 150 is high. By using laser, the obtained metallic pattern can have a very precise pattern outline. Also, as the scanning of laser is adaptable to the topography or configuration of the substrate, the metallic pattern can be formed on a planar surface or over a non-planar object.

The polymer substrate 110 may be a part or parts of an electronic device, such as a smart phone or a tablet PC, and the metallic pattern 150 may be an antenna part or a three-dimensional circuit incorporated within the electronic device. The polymer substrate and the metallic pattern formed thereon may be an injection-molded thermoplastic part with integrated electronic circuit traces, for example. The manufacturing method of the present invention may be applied to produce a molded interconnect device (MID), or parts (such as handset antenna or 3D electronic circuitry) of electronic products in the fields of consumer electronics, telecommunication, automobiles and/or medical instruments.

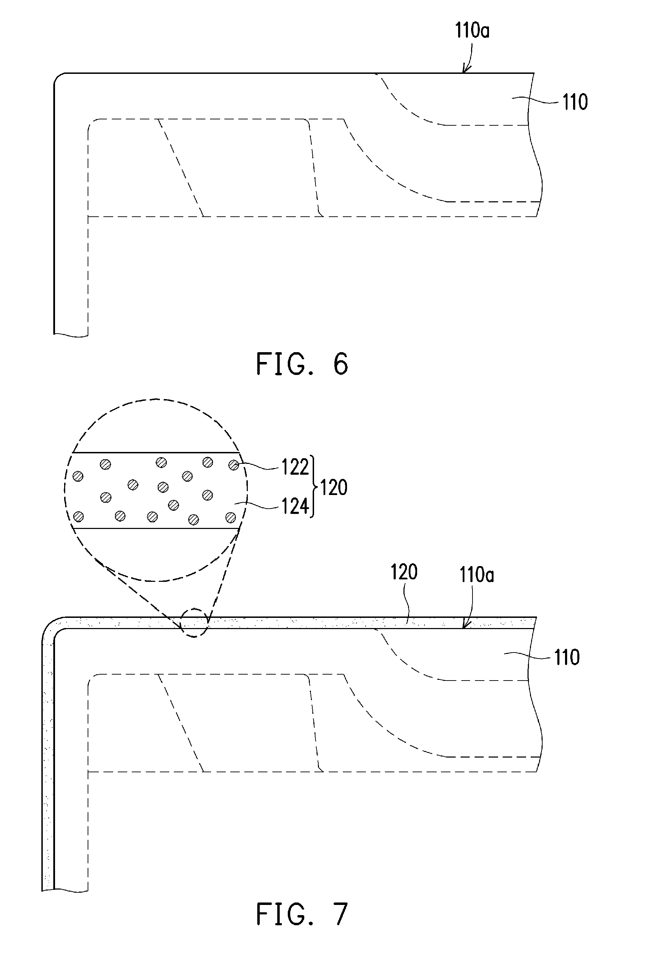

Figures 6-10 schematically illustrate a method of forming a metallic pattern on a polymer substrate according to an embodiment of the present invention. Referring to Figure 6, a polymer substrate 110 is provided. The polymer substrate 110 may be a polymer film, a casing body or even a circuit board, and may be made of a polymer material by injection molding technology. The polymer material may be nylons, polycarbonates (PC), acrylonitrile butadiene styrene (ABS), PC/ABS, polyethylene terephthalate (PET), polyether ether ketone (PEEK), liquid crystal polymers (LCP) or any suitable plastic material(s). The polymer substrate 110 needs not to be made of LDS-specific polymers (i.e. the polymer materials specifically designed for the laser direct structuring (LDS) process). The polymer substrate 110 may be a part or parts of an electronic device, and the electronic device may be, for example, a smart phone or a tablet PC, and the metallic pattern may be an antenna part or a three-dimensional circuit incorporated within the electronic device.

Subsequently, referring to Figure 7, a mixture layer 120 is formed on the surface 110a of the polymer substrate 110 by spraying, spin coating, dip coating, screen printing, pad printing or smearing, for example. The mixture layer 120 includes at least nanoparticles 122 and an active carrier medium 124. The nanoparticles 122 may be metallic nanoparticles made of copper oxide, or metal nanoparticles made of copper, silver or gold, for example. Preferably, the nanoparticles 122 may be copper oxide nanoparticles, for example. The nanoparticles may have an average size below 100 nm, for example. The content of the nanoparticles 122 of the mixture layer 120 may be 10 wt%∼20 wt%, relative to the total weight of the mixture layer 120. The material of the active carrier medium 124 may be polyvinylpyrrolidone (PVP), polyethylene oxide (PEO) and the like. In general, the active carrier medium 124 may be removed in the subsequent process by solvent washing and laser treatment, for example.

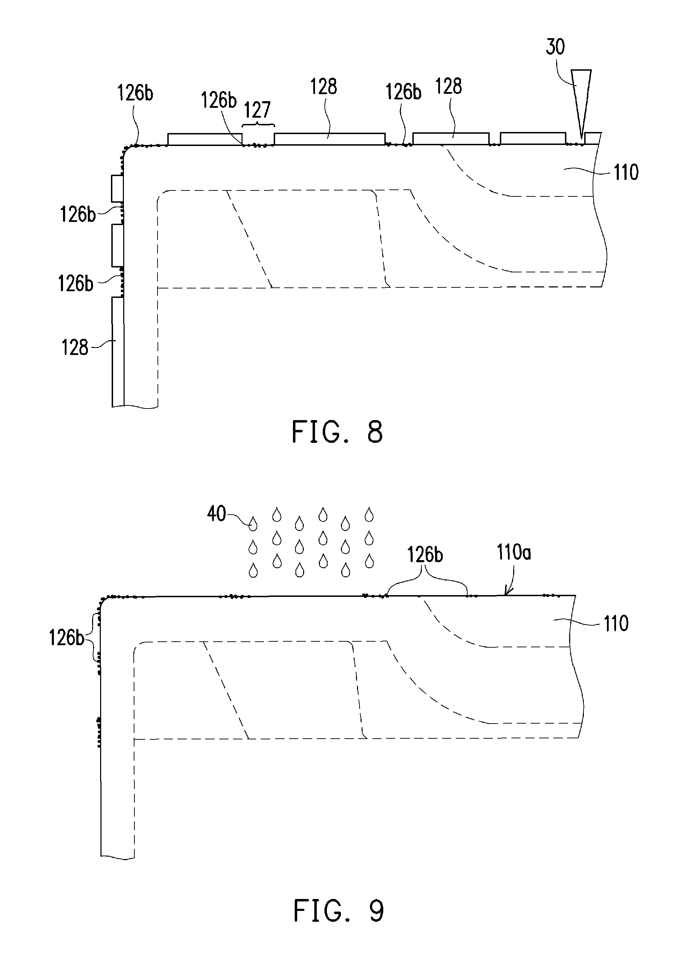

Referring to Figure 8, a laser process 30 is performed to treat a portion of the mixture layer 120 to form active seed residues 126b. The active seed residues 126b may be conductive or non-conductive residues. In principles, the active seed residues 126b are almost uniformly distributed over the region of the treated portion 127 of the mixture layer 120. The distribution range of the active seed residues 126b (i.e. the position of the treated portion 127) corresponds the position of the metallic pattern to be formed in the subsequent process. The type of the laser used in the laser process depends on the type and size of the nanoparticles 122 within the mixture layer 120. For treating the copper oxide nanoparticles, the laser used in the laser process 30 may be a ultraviolet (UV) laser at 355 nm with a power of 0.2∼0.4 W and 80% overlapping of laser spots for example. Alternatively, an infrared (IR) laser at 1064 nm with a power of 3 W and 75% overlapping of laser spots may be used. For treating the silver nanoparticles, the laser used in the laser process 30 may be a green light laser at 532 nm or an IR laser at 1064 nm, for example. Basically, the intensity of the laser may be relatively lower due to high surface area and absorption of the nanoparticles through surface plasmon resonance effect. For example, the laser process 30 is a laser ablation and activation process.

Upon laser illumination, nanoparticles, especially metal or metallic nanoparticles, efficiently generate heat (release heat) and the released heat transfers from the nanoparticles to the surrounding matrix or medium. The heating effect of the nanoparticles becomes strongly enhanced under plasmon resonance or when the laser frequency hits the collective resonance of the nanoparticle.

Taking advantages of the heating effect enhanced under plasmon resonance, the nanoparticles 122 in the treated portion of the mixture layer 120 are fused and turned into the active seed residues 126b during the laser process 30 and the active seed residues 126b are tightly fixed to the surface 110a. As the content of the nanoparticles 122 is merely about 10 wt%∼20 wt% and the nanoparticles 122 are not densely dispersed in the mixture layer 120, the obtained active seed residues 126b are not crowdedly formed together. Using the nanoparticles made of copper oxide as an example, the active seed residues 126b may be discontinuous copper residues distributed over the region of the treated portion 127. The active seed residues 126b distributed in a pattern can function as the seed pattern for the subsequent electroless plating process. Because the formation of the active seed residues 126b is activated by laser, the location and the shape of the pattern can be precisely controlled.

Referring to Figure 9, after the laser process 30, a cleaning process 40 is performed to remove the untreated portion 128 (see Figure 8) of the mixture layer 120 to expose the surface 110a of the polymer substrate 110, while the active seed residues 126b are remained on the surface 110a of the polymer substrate 110. The solvent used in the cleaning process may be water, acetone or suitable alcohols, for example.

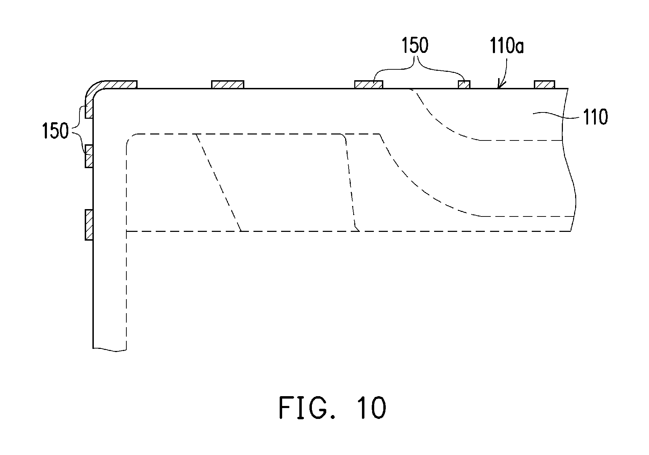

Referring to Figure 10, the polymer substrate 110 and the active seed residues 126b remained on the surface 110a of the polymer substrate 110 are further processed with an electroless plating process to form a metallic pattern 150. As the active seed residues 126b functions as the seed pattern for electroless plating, the metallic pattern 150 is formed exactly on the distribution region of the active seed residues 126b. The distribution density of the active seed residues 126b can be controlled by adjusting the content of the nanoparticles in the mixture layer. In general, the distribution density of the active seed residues 126b may be closely packed enough to form a thin layer as the metallic pattern. However, it is not necessary for the active seed residues 126b to form an integral thin layer, as long as the active seed residues 126b stay close to one another and maintain a pattern for the subsequent electroless plating process. The metallic pattern 150 may have a thickness no more than 20 microns, for example. No electroless plating occurs to the exposed polymer surface 110a corresponding to the untreated portion 128. The active seed residues 126b can be easily incorporated into the metallic pattern 150 during the electroless plating process and both may be viewed as an integral body. For example, the active seed residues 126b may be copper residues, the electroless plating process may be an electroless copper plating process and the metallic pattern 150 may be a copper pattern. The metallic pattern 150 may be composed of a continuous pattern or discontinuous patterns. Also, since the distribution location and the shape of the active seed residues 126b can be precisely controlled, the pattern fidelity of the metallic pattern 150 is high. By using laser, the obtained metallic pattern can have a very precise pattern outline. Also, as the scanning of laser is adaptable to the topography or configuration of the substrate, the metallic pattern can be formed on a planar surface or over a non-planar object.

The polymer substrate 110 may be a part or parts of an electronic device, such as a smart phone or a tablet PC, and the metallic pattern 150 may be an antenna part or a three-dimensional circuit incorporated within the electronic device. The polymer substrate and the metallic pattern formed thereon may be an injection-molded thermoplastic part with integrated electronic circuit traces, for example. The manufacturing method of the present invention may be applied to produce a molded interconnect device (MID), or parts (such as handset antenna or 3D electronic circuitry) of electronic products in the fields of consumer electronics, telecommunication, automobiles and/or medical instruments.

Compared with the prior laser direct structuring (LDS) technology, the manufacturing method of the present invention can be applied to any suitable polymer substrate to form the metallic pattern and there is no need to use LDS-specific polymer material(s), which are more expensive and with high color dependency. By using the manufacturing method of the present invention, nanoparticles of lower costs (e.g. copper oxide nanoparticles) may be used. In addition, a reasonable amount of nanoparticles is needed to form the conductive pattern of a minimum thickness. By using laser, the obtained metallic pattern can have a very precise pattern layout and can be formed on a planar surface or over a non-planar contour.

By using the manufacturing method of the present invention, the production costs may be lower and the flexibility of processing becomes higher for more choices in substrate materials. Also, high quality products may be manufactured by providing products with high pattern fidelity and less color dependency of the substrate.

The manufacturing method described in the embodiments can be equitably applied to form the circuits, wirings or metallic parts for portable electronic devices.

## Claims

1. A method of forming a metallic pattern (150) on a polymer substrate (110), comprising:
providing a polymer substrate (110);
forming a mixture layer (120) on a surface (110a) of the polymer substrate (110), wherein the mixture layer (120) includes an active carrier medium (124) and nanoparticles (122) dispersed in the active carrier medium (124);
performing a laser process (30) to treat a portion (127) of the mixture layer (120) to form a conductive portion (126a) or active seed residues (126b) on the surface (110a) of the polymer substrate (110);
performing a cleaning process (40) to remove an untreated portion (128) of the mixture layer (120) to expose the surface (110a) of the polymer substrate (110), while the conductive pattern (126a) or the active seed residues (126b) are remained on the surface (110a) of the polymer substrate (110); and
subjecting the conductive pattern (126a) or the active seed residues (126b) on the polymer substrate (110) to a plating process to form the metallic pattern (150) on the conductive pattern (126a) or the active seed residues (126b).

2. The method according to claim 1, wherein the plating process is an electroplating process and the conductive pattern (126a) is subjected to the electroplating process to form the metallic pattern (150).

3. The method according to claim 1, wherein the plating process is an electroless plating process and the active seed residues (126b) are subjected to the electroless plating process to form the metallic pattern (150).

4. The method according to claim 1, wherein a material of the polymer substrate (110) includes nylons, polycarbonates (PC), acrylonitrile butadiene styrene (ABS), PC/ABS, polyethylene terephthalate (PET), polyether ether ketone (PEEK), polytetrafluoroethylene (PTFE) or liquid crystal polymers (LCP).

5. The method according to claim 1, wherein a material of the nanoparticles (122) includes copper oxide, copper, silver or gold.

6. The method according to claim 1, wherein a material of the nanoparticles (122) includes copper oxide, the laser process (30) is performed by using a UV laser at 355 nm with a power of 0.2∼0.4 W and 80% overlapping and the laser process (30) is a laser ablation process.

7. The method according to claim 6, wherein the conductive pattern (126a) is a copper layer.

8. The method according to claim 2 or 3, wherein the metallic pattern (150) includes a copper pattern.

9. The method according to claim 1, wherein a content of the nanoparticles (122) in the mixture layer (120) ranges from 20 wt% to 40 wt%, relative to a total weight of the mixture layer (120).

10. The method according to claim 6, wherein the active seed residues (126b) are copper residues.

11. The method according to claim 1, wherein a material of the nanoparticles (122) includes silver, the laser process (30) is performed by using a green light laser at 532 nm or an IR laser at 1064 nm and the laser process (30) is a laser ablation and activation process.

12. The method according to claim 1, wherein the nanoparticles (122) have an average size below 100 nm.

13. The method according to claim 1, wherein a material of the active carrier medium (124) includes polyvinylpyrrolidone (PVP) or polyethylene oxide (PEO).

14. The method according to claim 1, wherein forming the mixture layer (120) includes forming the mixture layer (120) by spraying, spin coating, dip coating, screen printing, pad printing or smearing.

15. The method according to claim 1, wherein a position of the conductive pattern (126a) or the active seed residues (126b) corresponds to a position of the metallic pattern (150).
